# EUROPÄISCHE PATENTSCHRIFT

(11) **EP 3 551 949 B1**
(45) Veröffentlichungstag und Bekanntmachung des Hinweises auf die Patenterteilung: **03.04.2024**
(21) Anmeldenummer: 17807813.5
(22) Anmeldetag: 24.11.2017
(51) Int. Cl.: F25D 23/00, F25D 29/00

(54) **KÄLTEGERÄT MIT VERTEILTEN ELEKTRISCHEN EINRICHTUNGEN**
REFRIGERATING APPLIANCE HAVING SPREAD ELECTRIC DEVICES
RÉFRIGÉRATEUR AYANT DES DISPOSITIFS ÉLECTRIQUES ÉTALÉS

(30) Priorität: 12.12.2016 DE 102016224705
(43) Veröffentlichungstag der Anmeldung: 16.10.2019
(73) Patentinhaber: BSH Hausgeräte GmbH, 81739 München (DE)
(72) Erfinder: WIEDENMANN, Matthias, 89189 Neenstetten (DE); KRAUSS, Harald, 73431 Aalen (DE); WERTS, Thomas, 89293 Kellmünz (DE); XIAO, Xiang, 210046 Nanjing (CN)
(86) Internationale Anmeldenummer: PCT/EP2017/080399
(87) Internationale Veröffentlichungsnummer: WO 2018/108491

(56) Entgegenhaltungen:
- DE-A1- 10 221 898
- DE-A1-102013 209 747
- DE-A1-102014 118 597
- JP-A- S6 089 669
- JP-A- H08 205 265
- JP-A- 2001 116 429
- JP-A- 2003 065 658
- US-A- 3 825 703
- US-A- 6 101 819
- US-A1- 2008 164 758
- US-A1- 2015 194 749

## Beschreibung

Die vorliegende Erfindung betrifft ein Kältegerät mit mehreren örtlich beabstandeten, insbesondere an verschiedenen Orten eines Gerätegehäuses verteilten elektrischen Einrichtungen. EP 1 167 902 A2 beschreibt ein solches Elektrogerät, bei dem Anschlusskabel der einzelnen elektrischen Einrichtungen an einer zentralen Verteilerbox angesteckt sind. Die Verkabelung eines solchen Geräts ist mit erheblichem Arbeitsaufwand verbunden, da für jede elektrische Einrichtung das jeweils passende Kabel ausgesucht und einzeln verlegt und an Verteilerbox und elektrische Einrichtung angeschlossen werden muss. Deswegen hat es sich auf vielen Gebieten eingebürgert, gerätespezifisch vorkonfektionierte Kabelbäume zu verwenden, um in einem Elektrogerät verteilte elektrischen Einrichtungen mit elektrischer Energie zu versorgen und/oder Signale zwischen den elektrischen Einrichtungen zu übermitteln.

Die diversen elektrischen Einrichtungen eines solchen Elektrogeräts können vielen verschiedenen Typen angehören, und die Leitungen des Kabelbaums, mit denen eine elektrische Einrichtung verbunden werden muss, sind je nach Typ der Einrichtung unterschiedlich. Um sicherzustellen, dass jede elektrische Einrichtung korrekt angeschlossen wird, sind die Anschlussstellen eines Kabelbaums herkömmlicherweise mit Steckern unterschiedlicher Typen bestückt, die jeweils nur mit den komplementären Steckern derjenigen elektrischen Einrichtungen zusammenpassen, für die sie vorgesehen sind.

Ein Nachteil des Kabelbaums ergibt sich aus der Tatsache, dass die an einem gegebenen Ort des Gerätegehäuses einzubauenden elektrischen Einrichtungen von einem Gerät zum anderen variieren können. So können an sich funktionsgleiche elektrische Einrichtungen, die aus unterschiedlichen Quellen bezogen werden und wahlweise bei der Fertigung desselben Modells von Elektrogerät verwendet werden können, sich in den von ihnen benötigten elektrischen Anschlüssen unterscheiden. Wenn aufbauend auf einem gleichen Gerätegehäuse verschiedene Modelle des Elektrogeräts gefertigt werden, können die an einem gegebenen Ort des Gerätegehäuses einzubauenden elektrischen Einrichtungen von Modell zu Modell unterschiedlich sein. In beiden Fällen muss der an diesem Einbauort platzierte Stecker des Kabelbaums die jeweils benötigten Anschlüsse aufweisen. Die Folge daraus ist, dass viele verschiedene Modelle des Kabelbaums gefertigt und bereitgehalten werden müssen, um für jedes einzelne zu fertigende Elektrogerät unter Berücksichtigung der darin zu montierenden elektrischen Einrichtungen den jeweils passenden Kabelbaum auszuwählen. Diese Modellvielfalt steigert die Kosten der Kabelbäume und erhöht den Aufwand und die Wahrscheinlichkeit von Fehlern bei der Montage der Elektrogeräte.

In vielen Kabelbäumen werden Leitungen benötigt, die sich zwischen mehr als zwei Anschlussstellen erstrecken. Solche Leitungen können als Y-Verzweigungen realisiert werden, bei denen wenigstens zwei Leitungsabschnitte an einer Verzweigung des Kabelbaums miteinander verbunden sind, doch die Realisierung solcher Verzweigungen ist aufwendig und kostspielig. Eine andere Möglichkeit, eine solche Leitung zu bilden, ist, zwei Leitungsabschnitte mit einem gleichen Kontakt eines Steckverbinders an einer Anschlussstelle des Kabelbaums zu verbinden, doch dies erhöht den Platzbedarf der Kontakte und macht die Steckverbinder sperrig.

Beispielsweise aus der JP 2003 065658 A ist eine Leiterplattenverbindungsstruktur für eine Steuerung eines Kühlschranks bekannt.

Weiter ist aus der JP H08 205265 A ein Verdrahtungskontrollsystem bekannt, bei dem der Verdrahtungsaufwand reduziert ist.

Aufgabe der Erfindung ist, ein Kältegerät zu schaffen, bei dem trotz eines komplexen Aufbaus mit über verschiedene Einbauorte verteilten elektrischen Einrichtungen und trotz der Möglichkeit, dass die elektrischen Einrichtungen eines Einbauorts von einem Gerät zum nächsten variieren können, die Modellvielfalt der benötigten Kabelbäume reduziert werden kann.

Die Aufgabe wird gelöst, indem bei einem Kältegerät mit mehreren in einem Gerätegehäuse verteilt angeordneten elektrischen Einrichtungen und einem die elektrischen Einrichtungen versorgenden Kabelbaum wenigstens eine erste Anschlussstelle des Kabelbaums einen kabelbaumseitigen Steckverbinder aufweist und diejenigen elektrischen Einrichtungen, die über die erste Anschlussstelle versorgt sind, mit dem kabelbaumseitigen Steckverbinder über einen einrichtungsseitigen Steckverbinder und einen mit beiden Steckverbindern zusammengesteckten Adapter verbunden sind, wobei der Adapter einen Leiter aufweist, der wenigstens zwei Kontakte des einrichtungsseitigen Steckverbinders miteinander verbindet.

Eine Anpassung an die an den einzelnen Einbauorten anzuschließenden elektrischen Einrichtungen kann dadurch erfolgen, dass an wenigstens einem dieser Einbauorte der Adapter zwischen den kabelbaumseitigen Steckverbinder und die elektrischen Einrichtungen eingefügt wird. Da die Anpassung an die am Einbauort vorhandenen elektrischen Einrichtungen über den Adapter erfolgt, kann der kabelbaumseitige Steckverbinder unabhängig von den einzubauenden Einrichtungen derselbe sein. Dies verringert erheblich die Modellvielfalt des Kabelbaums.

Um an denselben Steckverbinder angeschlossene elektrische Einrichtungen auch untereinander zu verbinden, weist der Adapter erfindungsgemäß einen Leiter auf, der wenigstens zwei Kontakte des einrichtungsseitigen Steckverbinders miteinander verbindet. Ein solcher Leiter ist insbesondere auf einer Leiterplatte mit wesentlich geringerem Aufwand realisierbar als innerhalb des Kabelbaums und trägt damit zur Vereinfachung von dessen Aufbau bei.

Wenn an mehreren Anschlussstellen des Kabelbaums solche Adapter verwendet werden, kann ein einziges Modell von Kabelbaum für alle auf einem gleichen Gerätegehäuse basierenden Gerätemodelle genügen. Dies vereinfacht erheblich die Fertigung, da beim Einbau des Kabelbaums in einem Gerätegehäuse noch nicht feststehen muss, welche elektrischen Einrichtungen an den Einbauorten montiert werden.

Der Adapter ist besonders einfach und platzsparend als Leiterplatte realisierbar; die Steckverbinder können dann Randsteckverbinder sein, die auf Kontakte an den Rändern der Leiterplatte aufgesteckt werden.

Im einfachsten Fall ist die Verbindung zwischen zwei Kontakten der Leiterplatte durch eine Leiterbahn der Leiterplatte gebildet, er kann aber auch über ein an der Leiterplatte angelötetes Bauteil verlaufen. Die solcherart verbundenen Kontakte können ein kabelbaumseitiger und ein einrichtungsseitiger Kontakt sein, es kann sich aber auch um zwei kabelbaumseitige oder zwei einrichtungsseitige Kontakte handeln. Die Verwendung eines angelöteten Bauteils ist insbesondere dann vorteilhaft, wenn noch unmittelbar vor oder während des Zusammenbaus des Kältegeräts eine Anpassung des Adapters an die über ihn zu versorgenden elektrischen Einrichtungen vorgenommen werden muss.

Der Leiter kann mit dem kabelbaumseitigen Steckverbinder unverbunden sein, um eine Reihenschaltung von elektrischen Einrichtungen zu realisieren; für eine Parallelschaltung wird ein Leiter benötigt, der auch mit dem kabelbaumseitigen Steckverbinder verbunden ist.

Über eine solche Reihenschaltung können insbesondere eine Heizung und eine die Funktion der Heizung überwachende Temperatursicherung in Reihe verbunden werden, so dass ein Ansprechen der Temperatursicherung einen Stromfluss über die Heizung beenden kann.

Um ein Signal oder eine Versorgungsspannung zwischen mehr als zwei Anschlussstellen zu übertragen, muss ein Kabelbaum herkömmlicherweise eine verzweigte Struktur aufweisen, die aufwendig zu fertigen ist. Dieser Aufwand kann erfindungsgemäß reduziert werden, indem der Adapter einen Leiter aufweist, der wenigstens zwei Kontakte des kabelbaumseitigen Steckverbinders miteinander verbindet. Im Kabelbaum können dann eine erste Leitung, die sich von einem ersten der zwei Kontakte des kabelbaumseitigen Steckverbinders zu einer zweiten Anschlussstelle erstreckt, und eine zweite Leitung vorgesehen sein, die sich vom zweiten der zwei Kontakte zu einer dritten Anschlussstelle erstreckt.

Der kabelbaumseitige Steckverbinder kann jeweils einen einzigen Kontaktträger umfassen, an dem sämtliche Kontakte des Steckverbinders befestigt sind. Dies minimiert die Zahl der beim Einbau des Kabelbaums zu handhabenden Komponenten und ermöglicht eine effiziente Montage.

Es kann aber auch sinnvoll sein, die Kontakte des kabelbaumseitigen Steckverbinders auf jeweils mehrere Kontaktträger zu verteilen, die jeweils einzeln mit dem Adapter zusammengesteckt werden können. Dies erhöht zwar die Zahl der für die Montage erforderlichen Handgriffe, verringert aber dafür die erforderlichen Steckkräfte.

Wenn das Gerätegehäuse des Kältegeräts in mehrere Kammern unterteilt ist, sollten die von der ersten Anschlussstelle versorgten elektrischen Einrichtungen in einer ersten dieser Kammern untergebracht sein, für weitere Kammern können jeweils eigene Anschlussstellen vorgesehen sein.

Der Kabelbaum kann in eine Isolationsmaterialschicht des Gerätegehäuses eingebettet sein.

Zum Schutz ihrer Kontakte kann die erste Anschlussstelle ein Anschlussgehäuse umfassen, in dem die Steckverbinder und die Leiterplatte der Anschlussstelle untergebracht sind.

Bei einem in Kammern gegliederten Gerätegehäuse ist das Anschlussgehäuse der ersten Anschlussstelle zweckmäßigerweise an einer Wand der ersten Kammer montiert, d.h. der Kammer, in der sich die von dieser Anschlussstelle versorgten elektrischen Einrichtungen befinden.

Um die Einbauposition der Kapsel vorzugeben, kann die Wand eine Öffnung aufweisen.

Diese sollte durch die Kapsel dicht verschlossen sein, insbesondere um, wenn an einer Außenseite der Wand Isolationsmaterial ausgebracht wird, dessen Durchtritt ins Innere der Kammer zu verhindern.

Um eine solche Abdichtung zu erleichtern, kann die Kapsel einen die Steckverbinder und den Adapter aufnehmenden und in die Öffnung eingreifenden Kernbereich und einen sich um den Kernbereich erstreckenden, rings um die Öffnung an der Wand anliegenden Flansch aufweisen.

Dieser Flansch sollte zweckmäßigerweise auch kabelbaumseitige und einrichtungsseitige Leitungsdurchlässe der Kapsel voneinander trennen.

Weitere Merkmale und Vorteile der Erfindung ergeben sich aus der nachfolgenden Beschreibung von Ausführungsbeispielen unter Bezugnahme auf die beigefügten Figuren.

Es zeigen:
- Fig. 1: eine schematische Ansicht eines Kabelbaums mit Adaptern gemäß einer ersten Ausgestaltung der Erfindung;
- Fig. 2: eine schematische Ansicht eines Kabelbaums mit Adaptern gemäß einer zweiten Ausgestaltung der Erfindung;
- Fig. 3: eine Ansicht eines Innenbehälters eines Kältegeräts mit einer Anschlussstelle für den Kabelbaum;
- Fig. 4: eine Außenansicht der Anschlussstelle;
- Fig. 5: eine Innenansicht der Anschlussstelle, bei der ein einrichtungsseitiger Steckverbinder vom Adapter und dem kabelbaumseitigen Steckverbinder getrennt ist;
- Fig. 6: die Anschlussstelle der Fig. 5 mit auf den Adapter aufgestecktem kabelbaumseitigen Steckverbinder; und
- Fig. 7: die Anschlussstelle mit im Anschlussgehäuse versenkten Steckverbindern.

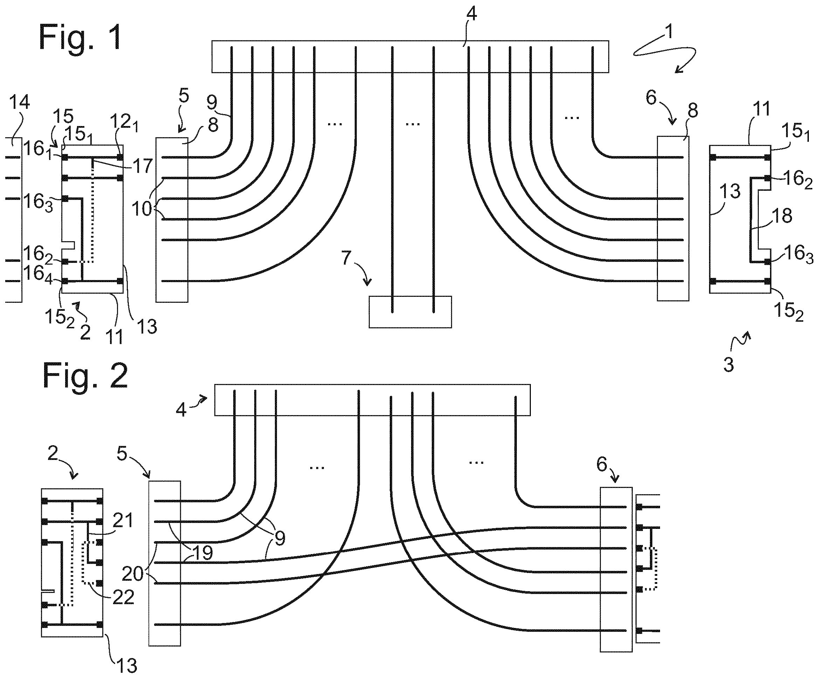

Fig. 1 zeigt eine schematische Darstellung einer Anordnung mit einem Kabelbaum 1 und Adaptern 2, 3 gemäß der Erfindung. Der Kabelbaum 1 hat eine zentrale und mehrere periphere Anschlussstellen 4, 5, 6, 7,... mit kabelbaumseitigen Steckverbindern 8 und eine Vielzahl von Leitungen 9, die an jeder Anschlussstelle 4, 5, 6, 7,... auf einen Kontakt 10 des Steckverbinders 8 herausgeführt sind.

An der zentralen Anschlussstelle 4 kann z.B. eine Steuereinheit eines Kältegeräts angeschlossen sein, die über den Kabelbaum 1 elektrische Einrichtungen an diversen Orten des Kältegeräts mit Betriebsenergie und Steuerinformationen versorgt oder Informationen von diesen empfängt. Über die Anschlussstelle 5 können z.B. elektrische Einrichtungen, die in einem Gefrierfach des Kältegeräts angeordnet sind, mit dem Kabelbaum 1 verbunden sein, während elektrische Einrichtungen eines Normalkühlfachs über die Anschlussstelle 6 angeschlossen sind. Weitere Anschlussstellen 7,... können je nach Bedarf für elektrische Einrichtungen in weiteren Fächern, für eine Benutzerschnittstelle etc. vorgesehen sein.

Die Leitungen 9 des Kabelbaums 1 sind verzweigungsfrei, d.h. jede Leitung 9 verbindet genau zwei Kontakte 10 von zwei Steckverbindern 8, einer davon an der zentralen Anschlussstelle 4. Dementsprechend zahlreich sind die Kontakte 10 an der zentralen Anschlussstelle 4.

Da die angeschlossenen elektrischen Einrichtungen von einer peripheren Anschlussstelle 5, 6, 7 zur anderen variieren, können die Steckverbinder 8 der peripheren Anschlussstellen 5, 6, 7 sich voneinander unterscheiden. Außerdem können sich die an jeder peripheren Anschlussstelle angeschlossenen elektrischen Einrichtungen von einem Gerät zum andern unterscheiden und insbesondere unterschiedliche Stecker aufweisen. Um diese mit den Steckverbindern 8 verbinden zu können, ist an jeder peripheren Anschlussstelle 5, 6, 7 ein jeweils für diese Anschlussstelle spezifischer Adapter 2, 3 vorgesehen.

Um die für das Zusammenstecken von kabelbaumseitigem Steckverbinder 8 und Adapter 2, 3 erforderlichen Steckkräfte zu begrenzen, kann der Steckverbinder 8 in mehrere Kontaktträger unterteilt sein, von denen jeder nur einen Teil der Kontakte 10 des Steckverbinders 8 umfasst, und die jeweils einzeln mit dem Adapter 2, 3 steckverbunden werden können. Der schnelleren Montage wegen bevorzugt ist ein Aufbau, bei dem alle Kontakte 10 in einem einzigen Kontaktträger zusammengefasst sind.

Die Adapter 2, 3 sind vorzugsweise als Leiterplatten 11 ausgebildet, und der Steckverbinder 8 oder die Kontaktträger, aus denen er sich zusammensetzt, sind Randsteckverbinder, die auf mit Kontaktpads 12 versehene Ränder 13 dieser Leiterplatten 11 aufgesteckt werden. Dabei muss nicht jedem Kontakt 10 der Randsteckverbinder ein Kontaktpad 12 des Adapters 2, 3 gegenüberliegen; in der Regel sind nur denjenigen Kontakten 10 Kontaktpads 12 zugeordnet, die von den über den betreffenden Adapter 2 oder 3 versorgten Einrichtungen tatsächlich genutzt werden.

Ein einrichtungsseitiger Steckverbinder 14 ist ebenfalls als Randsteckverbinder ausgebildet, der vorzugsweise auf einen dem Rand 13 gegenüberliegenden Rand 15 des Adapters 2 oder 3 aufgesteckt ist. Der Steckverbinder 14 kann wie der kabelbaumseitige Steckverbinder 8 einen einzigen Kontaktträger umfassen, in dem Kabel verschiedener elektrischer Einrichtungen zusammentreffen; hier kann es aber auch zweckmäßig sein, wenn jede elektrische Einrichtung jeweils mit einem eigenen Kontaktträger verbunden ist und diese einzeln auf getrennte Abschnitte 15₁, 15₂ des Rands 15 aufgesteckt werden können.

Um z.B. eine Versorgungsspannung, die dem Adapter 2 an einem einzigen Kontaktpad 12₁ zugeführt wird, an zwei elektrische Einrichtungen weiterzuleiten, können Kontaktpads 16₁, 16₂ an den Randabschnitten 15₁, 15₂ über eine sich verzweigende Leiterbahn 17 mit dem Kontaktpad 12₁ verbunden sein. Eine solche Verzweigung auf der Leiterplatte 11 zu realisieren ist wesentlich einfacher und kostengünstiger, als eine einzelne Leitung innerhalb des Kabelbaums zu verzweigen.

Die Verzeigung von Leiterbahnen 17 auf der Leiterplatte 11 des Adapters 2 ermöglicht z.B. eine parallele Versorgung einer elektrischen Einrichtung, deren Kontaktträger auf den Randabschnitt 15₁ aufgesteckt ist, und einer elektrischen Einrichtung mit auf den Randabschnitt 15₂ aufgestecktem Kontaktträger, indem beide über die Kontaktpads 16₁, 16₂ mit der Versorgungsspannung und über Kontaktpads 16₃, 16₄ mit Masse verbunden sind.

Der Adapter 3 weist eine Leiterbahn 18 auf, die Kontaktpads 16₂, 16₃ an getrennten Abschnitten 15₁, 15₂ des einrichtungsseitigen Rands 15 miteinander verbindet, die aber keine Verbindung zu einem Kontaktpad am dem Kabelbaum 1 zugewandten Rand 13 aufweist. Eine solche Leiterbahn 18 ermöglicht die Hintereinanderschaltung von zwei über denselben Adapter 3 versorgten elektrischen Einrichtungen wie etwa einem Türöffnungsschalter und einer Innenbeleuchtung des Kältegeräts oder einer Abtauheizung und einer Temperatursicherung, die dadurch, dass in ihr ein Schalter bei Überschreitung einer Grenztemperatur öffnet, den Stromfluss durch die Abtauheizung beenden kann.

Fig. 2 zeigt einen Kabelbaum 1 und Adapter 2, 3 gemäß einer zweiten Ausgestaltung der Erfindung. Die große Zahl von Kontakten 10 an der zentralen Anschlussstelle 4 des Kabelbaums 1 der Fig. 1 ist hier reduziert, indem nicht mehrere ein gleiches Signal oder eine gleiche Versorgungsspannung führende Leitungen 9 von der zentralen Anschlussstelle 4 zu verschiedenen peripheren Anschlussstellen verlaufen, sondern eine solche Leitung 9 von der Anschlussstelle 4 zunächst zu einem Kontakt 19 der Anschlussstelle 5 verläuft, der Kontakt 19 über eine Leiterbahn 21 oder 22 des an der Anschlussstelle 5 montierten Adapters 2 mit einem zweiten Kontakt 20 der Anschlussstelle 5 verbunden ist und eine weitere Leitung 9 sich vom Kontakt zur Anschlussstelle 6 erstreckt.

Wie in Fig. 1 und 2 durch einen z.T. gestrichelten Verlauf der Leiterbahnen 17, 21, 22 angedeutet, kann es notwendig sein, dass Leiterbahnen der Adapter 2, 3 einander kreuzen, ohne galvanisch verbunden zu sein. Solche Leiterbahnen können auf verschiedenen Seiten der Leiterplatten 11 strukturiert sein; sie können auch als auf der Leiterplatte 11 montierte, z.B. aufgelötete Brücken ausgebildet sein. Die Verwendung von Brücken ermöglicht insbesondere die Integration von selten eingebautem Zubehör in das Kältegerät, da durch Hinzufügen der Brücken ein vorhandener Adapter für solches Zubehör passend gemacht werden kann.

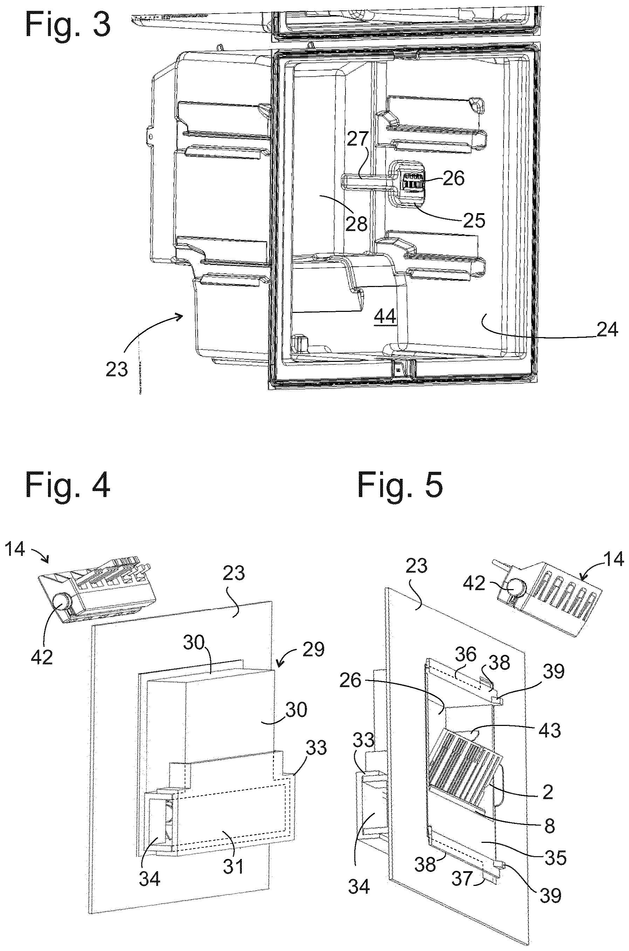

Fig. 3 zeigt eine perspektivische Ansicht eines Innenbehälters 23 einer unteren Kammer 44 in einem Kombinations-Kältegerät. Ein Innenbehälter einer oberen Kammer ist bruchstückweise dargestellt. An einer Seitenwand 24 des Innenbehälters 23 ist eine Ausbuchtung 25 geformt; am Boden der Ausbuchtung ist in die Außenwand eine Öffnung 26 geschnitten, durch die Teile einer Anschlussstelle wie etwa der Anschlussstelle 5 aus Fig.1 oder 2 zu sehen sind. In der Ausbuchtung 25 finden beim fertig montierten Kältegerät elektrische Einrichtungen wie etwa ein Temperatursensor oder eine Innenraumbeleuchtung Platz. Eine Rinne 27 verläuft von der Ausbuchtung 25 auf eine Rückwand 28 des Innenbehälters zu. Wenn beim fertigen Kältegerät das Innere des Innenbehälters in ein Lagerfach und eine Verdampferkammer unterteilt sind, verlaufen über die Rinne 27 Kabel von elektrischen Einrichtungen der Verdampferkammer wie etwa eines Lüfters, eines Verdampfertemperatursensors, einer Abtauheizung etc.

Fig. 4 zeigt in einer Ansicht von außen den Boden der Ausbuchtung. Die Öffnung 26 ist durch ein Anschlussgehäuse 29 verdeckt. Das Anschlussgehäuse 29 umfasst ein Hauptteil 30, das in später noch genauer beschriebener Weise am Innenbehälter 23 verrastet ist und an seiner vom Innenbehälter abgewandten Seite, angrenzend an eine Rückwand 32, eine in Fig. 4 gestrichelt eingezeichnete, langgestreckte Öffnung 31 aufweist, und einen Deckel 33, der die Öffnung 31 verschließt und zusammen mit dem Hauptteil einen seitlichen Kabelauslass 34 begrenzt. Der Kabelauslass 34 ist in Fig. 4 leer gezeigt; in der Praxis wird, bevor der Deckel 33 in der gezeigten Stellung am Hauptteil 30 montiert wird, ein kabelbaumseitiger Steckverbinder 8 durch die Öffnung 31 in den Hauptteil 30 eingeführt, und der Kabelauslass 34 ist durch einen von dem Steckverbinder 8 ausgehenden Ast des Kabelbaums 1 und eine den Ast umgebende Dichtung schaumdicht verschlossen, um zu verhindern, dass Schaum in das Anschlussgehäuse 29 oder gar den Innenbehälter 23 eindringt, wenn in fachüblicher Weise eine wärmedämmende Schaumstoffschicht an den Außenseiten des Innenbehälters 23 angebracht wird.

Fig. 5 zeigt das in der Öffnung 26 montierte Anschlussgehäuse 29 in einer Ansicht von innen. Eine mit dem Innenbehälter 23 bündige vordere Wand 35 des Hauptteils 30 verdeckt zu einem großen Teil den Steckverbinder 8. Der in den Steckverbinder 8 eingesteckte Adapter 2 ragt schräg durch die Öffnung 26 hindurch. In einem linken Abschnitt der Öffnung 26 sind deren oberer und unterer Rand 36, 37 hinter zwei vom Hauptteil 30 nach oben und unten abstehenden Stegen 38 verborgen. In einem schmalen, rechten Abschnitt der Öffnung 26 liegen die Ränder 36, 37 frei. Das Anschlussgehäuse 29 wird in der Öffnung 26 montiert, indem von außen kommend die Stege 38 mit ihrem linken Ende voran durch den breiten Abschnitt der Öffnung 26 hindurchgeführt und dann das Hauptteil 30 am Innenbehälter 23 anliegend verschoben wird, bis die Stege 38 die Öffnung 26 komplett passiert haben und ein am rechten Ende der Stege 38 angeformter Rastvorsprung 39 am rechten Rand der Öffnung 26 einrastet.

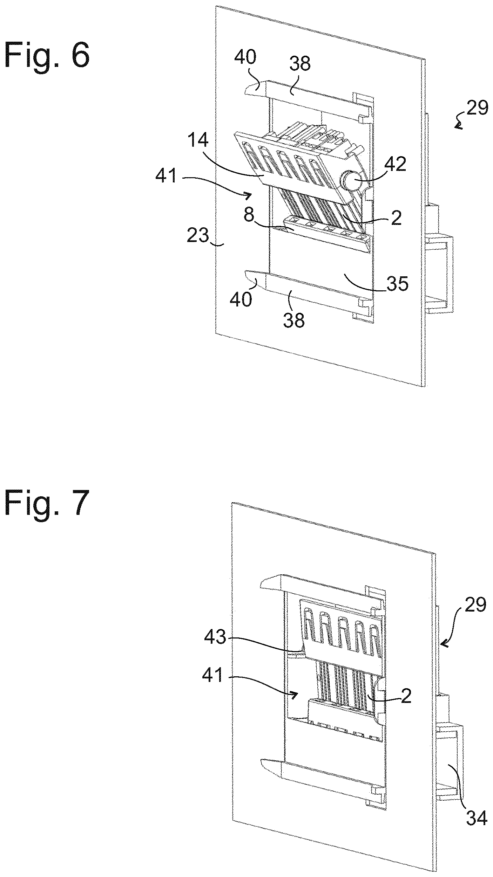

Um das Einführen der Stege 38 in die Öffnung 26 zu erleichtern, können die Stege 38 an ihren zuerst in die Öffnung 26 einzuführenden Enden wie in Fig. 6 gezeigt, mit Einführhilfen 40 versehen sein, die die Stege 38 ähnlich den Spitzen von Skiern verlängern und nach Anbringung in der Öffnung 26 schräg vom Innenbehälter 23 abstehen.

In Fig. 6 ist ferner der in Fig. 5 noch getrennt dargestellte einrichtungsseitige Steckverbinder 14 auf den Adapter 2 aufgesteckt. Im nächsten Schritt wird die Baugruppe 41 aus Adapter 2 und Steckverbindern 8, 14 in das Anschlussgehäuse 29 hineingeschwenkt, so dass, wie in Fig. 7 gezeigt, der Adapter 2 eine im wesentlichen vertikale Orientierung einnimmt und auch der Steckverbinder 14 vollständig im Anschlussgehäuse 29 verschwindet und nur noch die (in Fig. 7 nicht darstellten) Kabel, die sich von ihm zu den im Innenbehälter montierten elektrischen Einrichtungen erstrecken, sich durch die Öffnung 26 erstrecken.

Um einerseits die Baugruppe 41 in der Stellung der Fig. 7 zu fixieren und andererseits sicherzustellen, dass die Baugruppe 41 nur dann in die Stellung der Fig. 7 geschwenkt werden kann, wenn die Steckverbinder 8, 14 und der Adapter 2 weit genug zusammengesteckt sind, um eine sichere elektrische Kontaktierung zu gewährleisten, kann der Steckverbinder 14 mit zwei seitlichen Vorsprüngen 42 versehen sein, und das Anschlussgehäuse 29 weist zwei Gabeln 43 auf, die von seiner Rückwand 32 benachbart zu deren rechtem und linkem Rand zur Öffnung 26 hin vorspringen und von denen in Fig. 5 und Fig. 7 jeweils nur die Spitze eines Zinkens zu sehen ist. Der Abstand der Gabeln 43 von einer den Steckverbinder 8 abstützenden Unterseite des Anschlussgehäuses ist so gewählt, dass die Vorsprünge 42 nur dann zwischen die Zinken der Gabeln 43 einrücken können, wenn die Steckverbinder 8, 14 und der Adapter 2 korrekt zusammengesteckt sind. Der Abstand zwischen den Zinken ist so gewählt, dass sie einen zwischen sie eingeführten Vorsprung 42 zumindest reibschlüssig klemmen; sie können auch hinterschnitten sein, um einen formschlüssigen Eingriff des Vorsprungs 42 zu ermöglichen. Einführschrägen an den Spitzen der Zinken erleichtern das Einführen der Vorsprünge 42.

### BEZUGSZEICHEN

- 1: Kabelbaum
- 2: Adapter
- 3: Adapter
- 4: Anschlussstelle
- 5: Anschlussstelle
- 6: Anschlussstelle
- 7: Anschlussstelle
- 8: kabelbaumseitiger Steckverbinder
- 9: Leitung
- 10: Kontakt
- 11: Leiterplatte
- 12: Kontaktpad
- 13: Rand
- 14: einrichtungsseitiger Steckverbinder
- 15: Rand
- 16: Kontaktpad
- 17: Leiterbahn
- 18: Leiterbahn
- 19: Kontakt
- 20: Kontakt
- 21: Leiterbahn
- 22: Leiterbahn
- 23: Innenbehälter
- 24: Seitenwand
- 25: Ausbuchtung
- 26: Öffnung
- 27: Rinne
- 28: Rückwand
- 29: Anschlussgehäuse
- 30: Hauptteil
- 31: Öffnung
- 32: Rückwand
- 33: Deckel
- 34: Kabelauslass
- 35: vordere Wand
- 36: oberer Rand
- 37: unterer Rand
- 38: Steg
- 39: Rastvorsprung
- 40: Einführhilfe
- 41: Baugruppe
- 42: Vorsprung
- 43: Gabel
- 44: Kammer

## Patentansprüche

1. Kältegerät mit mehreren in einem Gerätegehäuse verteilt angeordneten elektrischen Einrichtungen und einem die elektrischen Einrichtungen versorgenden Kabelbaum (1), wobei wenigstens eine erste Anschlussstelle (5) des Kabelbaums (1) einen kabelbaumseitigen Steckverbinder (8) aufweist und diejenigen elektrischen Einrichtungen, die über die erste Anschlussstelle (5) versorgt sind, mit dem kabelbaumseitigen Steckverbinder (8) über einen einrichtungsseitigen Steckverbinder (14) und einen mit beiden Steckverbindern (8, 14) zusammengesteckten Adapter (2, 3) verbunden sind, **dadurch gekennzeichnet, dass** der Adapter (2, 3) einen Leiter (18) aufweist, der wenigstens zwei Kontakte des einrichtungsseitigen Steckverbinders miteinander verbindet.

2. Kältegerät nach Anspruch 1, **dadurch gekennzeichnet, dass** die Steckverbinder Randsteckverbinder sind und der Adapter (2, 3) eine Leiterplatte ist, deren Ränder Kontakte tragen, auf die die Randsteckverbinder aufgesteckt sind.

3. Kältegerät nach Anspruch 2, **dadurch gekennzeichnet, dass** unter den Kontakten des Adapters (2, 3) wenigstens zwei Kontakte (19, 20) über ein an der Leiterplatte angelötetes Bauteil verbunden sind.

4. Kältegerät nach einem der vorhergehenden Ansprüche, **dadurch gekennzeichnet, dass** der Leiter (18) mit dem kabelbaumseitigen Steckverbinder unverbunden ist.

5. Kältegerät nach einem der Ansprüche 1 bis 4, **dadurch gekennzeichnet, dass** der Leiter mit dem kabelbaumseitigen Steckverbinder verbunden ist.

6. Kältegerät nach einem der vorhergehenden Ansprüche, **dadurch gekennzeichnet, dass** der Adapter (2, 3) einen Leiter (21, 22) aufweist, der wenigstens zwei Kontakte des kabelbaumseitigen Steckverbinders (8) miteinander verbindet.

7. Kältegerät nach Anspruch 6, **dadurch gekennzeichnet, dass** der Kabelbaum eine erste Leitung (9), die sich von einem ersten der zwei Kontakte des kabelbaumseitigen Steckverbinders (8) zu einer zweiten Anschlussstelle (4) erstreckt, und eine zweite Leitung (9) aufweist, die sich vom zweiten der zwei Kontakte zu einer dritten Anschlussstelle (6) erstreckt.

8. Kältegerät nach einem der Ansprüche 1 bis 7, **dadurch gekennzeichnet, dass** der kabelbaumseitige Steckverbinder (8) jeweils einen einzigen Kontaktträger umfasst, an dem sämtliche Kontakte des Steckverbinders befestigt sind.

9. Kältegerät nach einem der Ansprüche 1 bis 7, **dadurch gekennzeichnet, dass** die Kontakte des kabelbaumseitigen Steckverbinders auf jeweils mehrere Kontaktträger verteilt sind.

10. Kältegerät nach einem der vorhergehenden Ansprüche, **dadurch gekennzeichnet, dass** das Gerätegehäuse in mehrere Kammern unterteilt ist und dass die von der ersten Anschlussstelle (5) versorgten elektrischen Einrichtungen in einer ersten (44) dieser Kammern untergebracht sind.

11. Kältegerät nach einem der vorhergehenden Ansprüche, **dadurch gekennzeichnet, dass** der Kabelbaum in eine Isolationsmaterialschicht des Gerätegehäuses eingebettet ist.

12. Kältegerät nach einem der vorhergehenden Ansprüche, **dadurch gekennzeichnet, dass** die erste Anschlussstelle (5) ein Anschlussgehäuse (29) umfasst, in dem die Steckverbinder (8, 14) und die Leiterplatte (11) der Anschlussstelle (5) untergebracht sind.

13. Kältegerät nach Anspruch 10 und Anspruch 12, **dadurch gekennzeichnet, dass** das Anschlussgehäuse (29) der ersten Anschlussstelle (5) an einer Wand (24) der ersten Kammer (44) montiert ist.

14. Kältegerät nach Anspruch 13, **dadurch gekennzeichnet, dass** das Anschlussgehäuse (29) eine Öffnung (26) der Wand (24) ausfüllt.

15. Kältegerät nach Anspruch 13 oder 14, **dadurch gekennzeichnet, dass** das Anschlussgehäuse (29) in die Öffnung (26) durch Verschieben in einer zur Oberfläche der Wand (24) parallelen Richtung einfügbar ist und zwei Randstege (38) aufweist, die durch einen quer zur Richtung der Verschiebung breiten Abschnitt der Öffnung (26) durchführbar sind und im montierten Zustand an der Wand beiderseits eines schmalen Abschnitts der Öffnung (26) anliegen.

16. Kältegerät nach Anspruch 15, **dadurch gekennzeichnet, dass** das Anschlussgehäuse (29) zur Kammer (44) hin offen ist und die Steckverbinder (8, 14) und der Adapter (2, 3) zwischen einer Stellung, in der sie im Anschlussgehäuse (29) aufgenommen sind, und einer Stellung schwenkbar sind, in der wenigstens der einrichtungsseitige Steckverbinder (14) aus dem Anschlussgehäuse (29) in die Kammer (44) vorspringt.

## Claims

1. Refrigeration appliance having multiple electric devices, which are arranged distributed in an appliance housing, and having a cable harness (1) that supplies the electric devices, wherein at least a first connection site (5) of the cable harness (1) has a plug connector (8) that is on the side facing the cable harness and the particular electrical devices that are supplied via the first connection site (5) are connected to the plug connector (8) that is on the side facing the cable harness via a plug connector (14) that is on the side facing the device and via an adaptor (2, 3) that plugs together with the two plug connectors (8, 14), **characterised in that** the adaptor (2, 3) has a conductor (18) that connects to one another at least two contacts of the plug connector that is on the side facing the device.

2. Refrigeration appliance according to claim 1, **characterised in that** the plug connectors are edge plug connectors and the adaptor (2, 3) is a circuit board, the edges of said circuit board carrying contacts that are plugged onto the edge plug connectors.

3. Refrigeration appliance according to claim 2, **characterised in that** of the contacts of the adaptor (2, 3) at least two contacts (19, 20) are connected via a component that is soldered onto the circuit board.

4. Refrigeration appliance according to one of the preceding claims, **characterised in that** the conductor (18) is not connected to the plug connector that is on the side facing the cable harness.

5. Refrigeration appliance according to one of claims 1 to 4, **characterised in that** the conductor is connected to the plug connector that is on the side facing the cable harness.

6. Refrigeration appliance according to one of the preceding claims, **characterised in that** the adaptor (2, 3) has a conductor (21, 22) that connects to one another at least two contacts of the plug connector (8) that is on the side facing the cable harness.

7. Refrigeration appliance according to claim 6, **characterised in that** the cable harness has a first cable (9) that extends from a first of the two contacts of the plug connector (8) that is on the side facing the cable harness to a second connection site (4), and said cable harness has a second cable (9) that extends from the second of the two contacts to a third connection site (6).

8. Refrigeration appliance according to one of claims 1 to 7, **characterised in that** the plug connector (8) that is on the side facing the cable harness comprises at least a single contact carrier to which all contacts of the plug connector are attached.

9. Refrigeration appliance according to one of claims 1 to 7, **characterised in that** the contacts of the plug connector that is on the side facing the cable harness are arranged distributed on respective multiple contact carriers.

10. Refrigeration appliance according to one of the preceding claims, **characterised in that** the appliance housing is subdivided into multiple chambers and that the electric devices that are supplied by the first connection site (5) are accommodated in a first (44) of these chambers.

11. Refrigeration appliance according to one of the preceding claims, **characterised in that** the cable harness is embedded in a layer of the appliance housing, said layer being formed from an insulating material.

12. Refrigeration appliance according to one of the preceding claims, **characterised in that** the first connection site (5) comprises a connection housing (29) that accommodates the plug connectors (8, 14) and the circuit board (11) of the connection site (5).

13. Refrigeration appliance according to claim 10 and claim 12, **characterised in that** the connection housing (29) of the first connection site (5) is installed on a wall (24) of the first chamber (44).

14. Refrigeration appliance according to claim 13, **characterised in that** the connection housing (29) completely fills an opening (26) of the wall (24).

15. Refrigeration appliance according to claim 13 or 14, **characterised in that** the connection housing (29) may be inserted into the opening (26) by means of being displaced in a direction that is parallel to the surface of the wall (24) and said connection housing has two edge connecting pieces (38) that may be guided through a wide section of the opening (26) transversely with respect to the direction of displacement and in the installed state on the wall said connection housing lies against both sides of a narrow section of the opening (26).

16. Refrigeration appliance according to claim 15, **characterised in that** the connection housing (29) is open toward the chamber (44) and the plug connectors (8, 14) and the adaptor (2, 3) may pivot between one position in which they are received in the connection housing (29) and one position in which at least the plug connector (14) that is on the side facing the device protrudes out of the connection housing (29) into the chamber (44).

## Revendications

1. Appareil frigorifique avec plusieurs dispositifs électriques répartis dans une carcasse d'appareil et un faisceau de câbles (1) alimentant les dispositifs électriques, dans lequel au moins un premier point de raccordement (5) du faisceau de câbles (1) présente un connecteur côté faisceau de câbles (8) et les dispositifs électriques alimentés via le premier point de raccordement (5) sont reliés au connecteur côté faisceau de câbles (8) via un connecteur côté dispositifs (14) et un adaptateur (2, 3) assemblé avec les deux connecteurs (8, 14), **caractérisé en ce que** l'adaptateur (2, 3) présente un conducteur (18) qui relie l'un à l'autre au moins deux contacts du connecteur côté dispositifs.

2. Appareil frigorifique selon la revendication 1, **caractérisé en ce que** les connecteurs sont des connecteurs de bord et l'adaptateur (2, 3) est un circuit imprimé, dont les bords portent des contacts sur lesquels les connecteurs de bord sont enfichés.

3. Appareil frigorifique selon la revendication 2, **caractérisé en ce que** parmi les contacts de l'adaptateur (2, 3), au moins deux contacts (19, 20) sont reliés via un composant soudé sur le circuit imprimé.

4. Appareil frigorifique selon l'une des revendications précédentes, **caractérisé en ce que** le conducteur (18) n'est pas relié au connecteur côté faisceau de câbles.

5. Appareil frigorifique selon l'une des revendications 1 à 4, **caractérisé en ce que** le conducteur est relié au connecteur côté faisceau de câbles.

6. Appareil frigorifique selon l'une des revendications précédentes, **caractérisé en ce que** l'adaptateur (2, 3) présente un conducteur (21, 22) qui relie au moins deux contacts du connecteur côté faisceau de câbles (8).

7. Appareil frigorifique selon la revendication 6, **caractérisé en ce que** le faisceau de câbles présente une première ligne (9), qui s'étend d'un premier parmi les deux contacts du connecteur côté faisceau de câbles (8) vers un deuxième point de raccordement (4) et une deuxième ligne (9) qui s'étend du deuxième parmi les deux contacts vers un troisième point de raccordement (6).

8. Appareil frigorifique selon l'une des revendications 1 à 7, **caractérisé en ce que** le connecteur côté faisceau de câbles (8) comprend respectivement un seul porte-contacts, auquel l'ensemble des contacts du connecteur sont fixés.

9. Appareil frigorifique selon l'une des revendications 1 à 7, **caractérisé en ce que** les contacts du connecteur côté faisceau de câbles sont répartis sur plusieurs porte-contacts respectifs.

10. Appareil frigorifique selon l'une des revendications précédentes, **caractérisé en ce que** la carcasse d'appareil est subdivisée en plusieurs chambres et **en ce que** les dispositifs électriques alimentés par le premier point de raccordement (5) sont logés dans une première (44) de ces chambres.

11. Appareil frigorifique selon l'une des revendications précédentes, **caractérisé en ce que** le faisceau de câbles est encastré dans une couche de matériau isolant de la carcasse d'appareil.

12. Appareil frigorifique selon l'une des revendications précédentes, **caractérisé en ce que** le premier point de raccordement (5) comprend une carcasse de raccordement (29) dans laquelle les connecteurs (8, 14) et le circuit imprimé (11) du point de contact (5) sont logés.

13. Appareil frigorifique selon la revendication 10 et la revendication 12, **caractérisé en ce que** la carcasse de raccordement (29) du premier point de raccordement (5) est montée sur une paroi (24) de la première chambre (44).

14. Appareil frigorifique selon la revendication 13, **caractérisé en ce que** la carcasse de raccordement (29) comble un orifice (26) de la paroi (24).

15. Appareil frigorifique selon la revendication 13 ou 14, **caractérisé en ce que** la carcasse de raccordement (29) est insérable dans l'orifice (26) par déplacement dans un sens parallèle à la surface de la paroi (24) et présente deux âmes de bord (38) insérables à travers une section large de l'orifice (26) transversale au sens de déplacement et contiguës, à l'état monté sur la paroi, de chaque côté à une section étroite de l'orifice (26).

16. Appareil frigorifique selon la revendication 15, **caractérisé en ce que** la carcasse de raccordement (29) est ouverte en direction de la chambre (44) et les connecteurs (8, 14) et l'adaptateur (2, 3) peuvent être pivotés entre une position dans laquelle ils sont accueillis dans la carcasse de raccordement (29) et une position dans laquelle au moins le connecteur côté dispositifs (14) fait saillie de la carcasse de raccordement (29) dans la chambre (44).
